# FASCICULE DE BREVET EUROPEEN

(11) **EP 0 833 394 B1**
(45) Date de publication et mention de la délivrance du brevet: **10.09.2008**
(21) Numéro de dépôt: 97410106.5
(22) Date de dépôt: 25.09.1997
(51) Int. Cl.: H01L 29/87

(54) **Diode bidirectionnelle de protection, à retournement**
Bidirektionale Überkopfzündungsschutzdiode
Bidirectional, breakover protection diode

(30) Priorité: 25.09.1996 FR 9611901
(43) Date de publication de la demande: 01.04.1998
(73) Titulaire: STMicroelectronics S.A., 92120 Montrouge (FR)
(72) Inventeur: Simmonet, Jean-Michel, 37270 Verezt (FR)
(74) Mandataire: de Beaumont, Michel

(56) Documents cités:
- EP-A- 0 255 971
- WO-A-83/00582
- FR-A- 2 535 529
- US-A- 4 967 256
- J. M. S. NEILSON ET R. A. DUCLOS: "Avalanche Diode Structure" RCA TECHNICAL NOTES, no. 1343, mars 1984, PRINCETON US, pages 1-6, XP002033358

## Description

La présente invention concerne les composants de protection à retournement, couramment appelés diodes de Shockley ou thyristors sans gâchette, de type bidirectionnel.

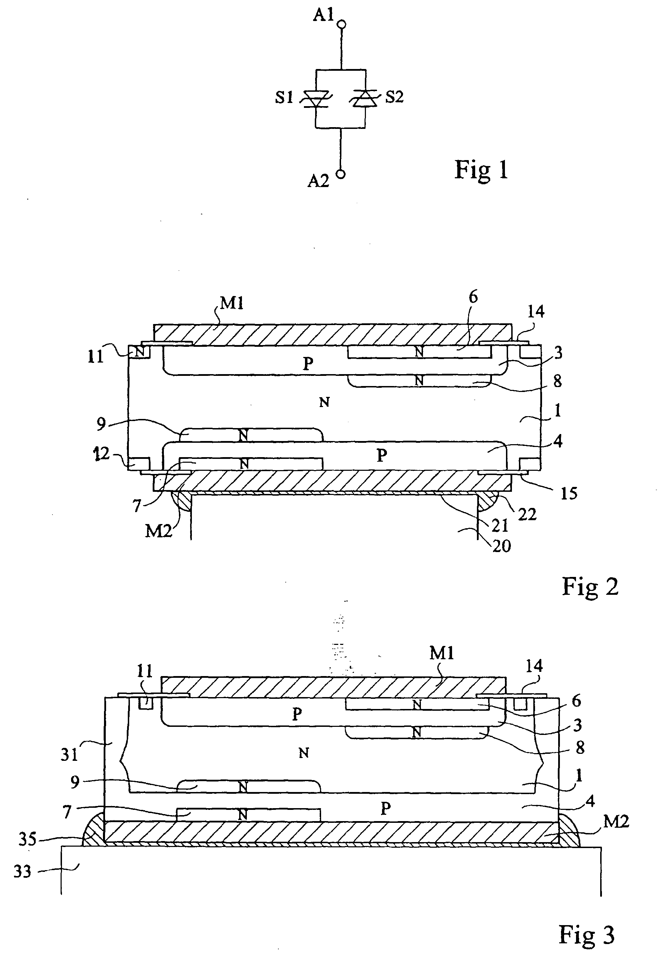

Le schéma d'une diode de Shockley bidirectionnelle apparaît en figure 1. Une première diode de Shockley S1 et une deuxième diode de Shockley S2 sont connectées en antiparallèle entre des bornes A1 et A2.

La figure 2 est une vue en coupe schématique d'un composant semiconducteur constituant de façon classique une diode de Shockley bidirectionnelle.

Le composant est élaboré à partir d'un substrat 1 de type N très faiblement dopé et comprend du côté de ses faces supérieure et inférieure des régions 3 et 4 de type P occupant la plus grande partie de la surface du composant. Chacune des régions 3 et 4 contient, de façon sensiblement complémentaire, une région de type N, respectivement 6 et 7. Sensiblement en regard de chacune des régions 6 et 7, à l'interface entre la région P respective et le substrat, sont disposées des régions de type N faiblement dopées 8 et 9. Les périphéries supérieure et inférieure du substrat sont entourées d'un anneau de type N fortement dopé, respectivement 11 et 12. Les périphéries des surfaces supérieure et inférieure sont revêtues de couches isolantes, couramment en oxyde de silicium, respectivement 14 et 15. Une métallisation supérieure M1 correspondant à l'électrode A1 recouvre les régions 3 et 6 et une métallisation inférieure M2 recouvre les régions 4 et 7. Ces métallisations s'arrêtent sur la couche périphérique d'oxyde, respectivement 14, 15.

Une première diode de Shockley verticale dont l'anode correspond à la face supérieure comprend les régions 3-1-9-4-7. Une deuxième diode de Shockley dont la cathode correspond à la face supérieure comprend les régions 6-3-8-1-4. Pour chacune de ces diodes, c'est l'interface (3-8 ; 4-9) entre la région interne de type P et la région correspondante de type N faiblement dopée qui détermine la tension de claquage.

Généralement, on cherche à monter par brasure la face inférieure de ce composant sur une plaque de base formant répartiteur thermique. Dans le cas du composant représenté en figure 2, cette plaque de base 20 doit présenter une surface inférieure à la surface du composant et de la métallisation de face inférieure M2. En effet, quand on monte le composant sur cette plaque par une couche de brasure 21, la brasure tend à déborder latéralement pour former des bourrelets 22. Si la métallisation M2 s'étendait sur toute la face inférieure du composant et que la plaque 20 était plus étendue que ce composant, ce bourrelet de brasure déborderait sur la face latérale du composant et court-circuiterait les régions 4 et 7 avec le substrat 1. La fonction du composant ne serait plus assurée ou très dégradée.

Ainsi, une tendance de la technique actuelle, destinée à simplifier le montage, est de réaliser des composants dits à caisson, c'est-à-dire comportant sur toute leur périphérie une région du même type de dopage que l'une des couches de la face inférieure. Ainsi, un court-circuit entre la face inférieure et la face latérale ne nuit plus au fonctionnement du composant.

La transformation du composant de la figure 2 en un composant à caisson est illustrée en figure 3. Le caisson 31 est constitué de diffusions profondes de type P s'étendant à partir des faces inférieure et supérieure et rejoignant la région de type P de face inférieure 4. On notera que, dans ce cas, le passage de la structure simple de la figure 2 à la structure à caisson de la figure 3 est relativement direct. En particulier, la disposition des régions 8 et 9 déterminant les tensions de claquage du composant n'est pas modifiée.

Comme le représente la figure 3, le composant peut être monté sur une plaque de répartiteur thermique 33 plus étendue que le composant et un éventuel bourrelet de brasure 35 n'affectera pas le fonctionnement du composant puisqu'il rejoint une région de même type de dopage que les régions utiles que l'on cherche à connecter par la métallisation de face inférieure M2. Un composant de ce type est décrit dans le brevet US-A-4 967 256.

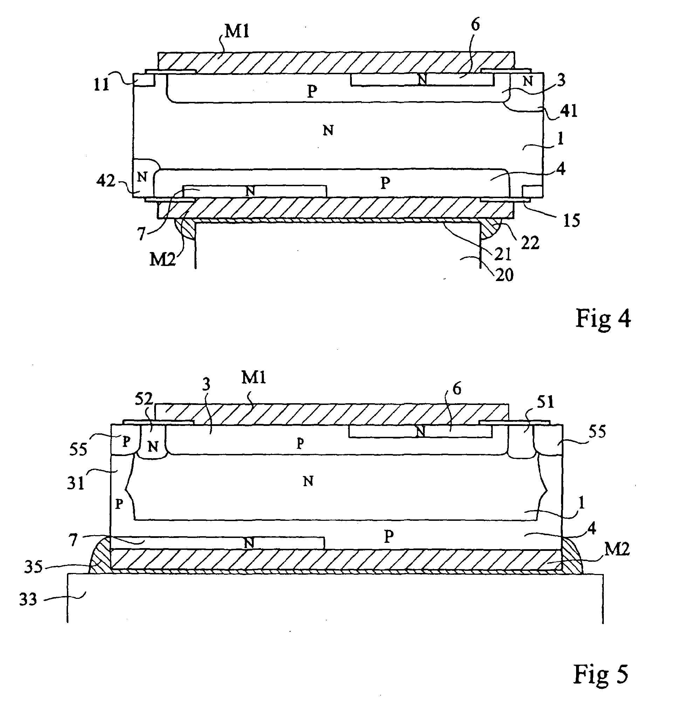

La figure 4 représente une vue en coupe schématique d'un autre mode de réalisation selon l'art antérieur d'une double diode de Shockley. Le composant est à nouveau formé à partir d'un substrat 1, comprenant des régions de type P supérieure et inférieure 3 et 4 dans lesquelles sont formées des régions de type N supérieure et inférieure 6 et 7. Les régions de type N faiblement dopées 8 et 9 à l'interface entre les régions de type P et le substrat sont remplacées par des régions latérales de type N faiblement dopées 41 et 42. Cette disposition permet d'atteindre une tension de claquage plus faible que celle de la figure 2. En effet, la tension de claquage dépend du gradient de dopage au niveau de la jonction susceptible de claquer. Dans le cas de la figure 2, au niveau de cette jonction, on trouve le fond d'une diffusion P, c'est-à-dire une région relativement peu dopée. Par contre, dans le cas de la figure 4, la partie supérieure de la diffusion P (3 ou 4) se trouve en contact avec la région N⁻ 41 ou 42. Il en résulte que l'on peut obtenir des tensions de claquage plus faibles, ce qui est recherché pour certaines applications.

Toutefois, le composant de la figure 4 présente les mêmes inconvénients de montage que celui illustré en figure 2.

Un objet de la présente invention est de prévoir un composant de protection du type double diode de Shockley présentant une caractéristique de claquage en surface comme le composant décrit en relation avec la figure 4 et pouvant avoir une structure à caisson pour simplifier son montage.

Alors que la transformation du composant de la figure 2 en celui de la figure 3 paraissait relativement simple, il n'existe a priori pas de moyen simple de transformer le composant de la figure 4 en une structure à caisson. Ainsi, la présente invention prévoit de modifier fortement la structure de ce composant.

Plus particulièrement, la présente invention prévoit un composant bidirectionnel à retournement comprenant un substrat de type N faiblement dopé, une région supérieure de type P s'étendant sur la plus grande partie de la surface supérieure du composant sauf à sa périphérie, une couche uniforme inférieure de type P s'étendant sur toute la face inférieure du composant, des régions sensiblement complémentaires de type N respectivement formées dans la région supérieure et la couche inférieure, un caisson périphérique de type P ; une région surdopée de type P à la surface supérieure du caisson, et des régions de type N faiblement dopées entre, et en contact direct avec, la périphérie de la région supérieure et le caisson.

Selon un mode de réalisation de la présente invention, la région surdopée de type P a le même niveau de dopage que la région supérieure.

Selon un mode de réalisation de la présente invention, les régions de type N faiblement dopées ont le même niveau de dopage que les régions sensiblement complémentaires de type N.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le schéma d'une double diode de Shockley ;
les figures 2 à 4 représentent des vues en coupe de diverses structures de doubles diodes de Shockley selon l'art antérieur ; et
la figure 5 représente une vue en coupe d'un exemple de réalisation d'une double diode de Shockley selon la présente invention.

Comme le représente la figure 5, le composant selon la présente invention est formé à partir d'un substrat 1 de type N très faiblement dopé. Du côté de la face supérieure et sur la plus grande partie de sa surface, est formée une région 3 de type P. Du côté de la face inférieure et sur toute sa surface est formée une région 4 de type P. Des régions de type N sensiblement complémentaires 6 et 7 sont formées dans les régions respectives 3 et 4. La périphérie du composant est entourée d'un caisson 31 de type P formé par diffusion profonde à partir des faces supérieure et inférieure.

Entre des zones périphériques sensiblement opposées de la région 3 et le caisson périphérique 31 sont formées des régions de type N faiblement dopées 51 et 52. on pourra aussi former un anneau continu au lieu de deux régions distinctes. On préfère toutefois former des régions distinctes pour améliorer les caractéristiques des composants et réduire sa capacité.

En outre, la surface supérieure du caisson, notamment aux emplacements en contact direct avec les régions 51 et 52, est revêtue d'un anneau de type P 55 de même type que la région 3 et, de préférence, de même niveau de dopage.

Des métallisations M1 et M2 sont disposées comme dans le cas de la figure 3 et permettent le même type de montage sur une embase de grande dimension 33.

Le mode de fonctionnement du dispositif de la figure 5 n'est pas exactement le même que celui de la figure 4, du moins lors de sa phase initiale de fonctionnement.

En cas de surtension positive sur la métallisation supérieure, le courant circule à partir de la région 3 dans la région 52 par la jonction 3-52 en direct puis, par avalanche, à travers la jonction entre les régions 52 et 55. Ensuite, le circuit de courant circule par le caisson 31 et la couche inférieure 4 vers la métallisation M2. Après quoi, la jonction PN en direct entre les régions 4 et 7 devient passante et le thyristor 3-1-4-7 s'amorce.

Inversement, quand une surtension positive apparaît sur la métallisation inférieure, celle-ci passe par le caisson 1 vers la région 55, par la jonction en direct entre les régions 55 et 51 puis par la jonction en avalanche entre les régions 51 et 3 vers la métallisation M1, après quoi la jonction en direct entre les régions 3 et 6 devient passante et le thyristor 4-1-3-6 entre en conduction.

Ainsi, dans le cas d'une surtension positive sur la métallisation M1, c'est la jonction 52-55 qui détermine le seuil d'avalanche alors que, dans le cas d'une surtension positive sur la métallisation M2, c'est la jonction 51-3 qui détermine le seuil d'avalanche. C'est pourquoi une région périphérique 55 de même niveau de dopage que la région 3 a été prévue pour assurer la symétrie du dispositif. On notera d'ailleurs que l'on dispose là d'un moyen simple pour réaliser une double diode de Shockley à seuil de claquage distinct dans les deux directions en choisissant pour la région 55 un niveau de dopage différent de celui de la région 3.

La structure de la figure 5 atteint les objets visés, à savoir réaliser une double diode de Shockley à claquage en surface et à caisson. Cette structure est particulièrement simple. Notamment, par rapport aux diverses structures de l'art antérieur, elle ne comporte de régions de type N faiblement dopées (51, 52) que sur une seule face du composant, ce qui simplifie la fabrication.

Dans un mode de réalisation de la présente invention, le composant de la figure 5 a été fabriqué en utilisant la séquence de fabrication suivante :
- diffusion du caisson 31,
- diffusion simultanée des régions P 3, 4 et 55,
- diffusion des régions N 51 et 52 (cette étape pourrait être réalisée avant la précédente),
- diffusion des régions N 6 et 7,
- ouverture des couches d'oxyde et métallisation.

On notera que, dans une certaine plage de tensions de claquage, les régions 51 et 52 pourraient être formées en même temps que les régions 6 et 7 ce qui simplifie encore le processus de fabrication.

## Revendications

1. Composant bidirectionnel à retournement comprenant :
un substrat (1) de type N très faiblement dopé ;
une région supérieure (3) de type P s'étendant sur la plus grande partie de la surface supérieure du composant sauf à sa périphérie ;
une couche uniforme inférieure de type P (4) s'étendant sur toute la face inférieure du composant ;
des régions sensiblement complémentaires de type N (6, 7) respectivement formées dans la région supérieure et la couche inférieure ;
un caisson périphérique de type P (31) ;
une région surdopée de type P (55) à la surface supérieure du caisson ; et
des régions de type N faiblement dopées (51, 52) entre, et en contact direct avec, la périphérie de la région supérieure (3) et le caisson.

2. Composant selon la revendication 1, **caractérisé en ce que** ladite région surdopée de type P (55) a le même niveau de dopage que ladite région supérieure (3).

3. Composant selon la revendication 1, **caractérisé en ce que** lesdites régions de type N faiblement dopées (51, 52) ont le même niveau de dopage que lesdites régions sensiblement complémentaires de type N (6, 7).

## Claims

1. A bidirectional breack-over component, including:
a very lightly-doped N-type substrate (1);
an upper P-type region (3) extending over the largest part of the upper surface of the component except its circumference;
a lower P-type uniform layer (4) on the entire lower surface of the component;
substantially complementary N-type regions (6, 7) respectively formed in the upper region and in the lower layer;
a peripheral P-type well (31);
an overdoped P-type region (55) at the upper surface of the well; and
lightly-doped N-type regions (51, 52) between the circumference of the upper region (3) and the well, and in direct contact therewith.

2. A component according to claim 1, **characterized in that** the overdoped P-type region (55) has the same level of doping as the upper region (3).

3. A component according to claim 1, **characterized in that** the lightly-doped N-type regions (51, 52) have the same level of doping as the substantially complementary N-type regions (6, 7).

## Patentansprüche

1. Eine bidirektionale Kipp-Komponente bzw. Break-over-Komponente, die Folgendes beinhaltet:
ein sehr leicht dotiertes N-dotiertes Substrat (1);
eine obere P-dotierte Region (3), die sich über den größten Teil über von der oberen Oberfläche von der Komponente, mit Ausnahme ihres Umfangs, erstreckt;
eine untere P-dotierte uniforme Schicht (4) auf der gesamten unteren Oberfläche von der Komponente;
im Wesentlichen komplementäre N-dotierte Regionen (6, 7) die entsprechend in der oberen Region und in der unteren Schicht gebildet sind;
eine periphere P-dotierte Wanne (31);
eine überdotierte P- dotierte Region (55) an der oberen Oberfläche von der Wanne; und
schwachdotierte N-dotierte Regionen (51, 52) zwischen dem Umfang von der oberen Region (3) und der Wanne und im direkten Kontakt damit.

2. Komponente gemäß Anspruch 1, **dadurch gekennzeichnet dass** die überdotierte P-dotierte Region (55) das gleiche Niveau an Dotierung besitzt, wie die obere Region (3).

3. Komponente gemäß Anspruch 1, **dadurch gekennzeichnet, dass** die schwach dotierten N-dotierten Regionen (51, 52) das gleiche Niveau an Dotierung besitzen, wie die im Wesentlichen komplementären N-dotierten Regionen (6, 7)
